(19) **Europäisches Patentamt European Patent Office Office européen des brevets**

(11) **EP 4 598 047 B1**

(12) **FASCICULE DE BREVET EUROPEEN**

(45) Date de publication et mention
de la délivrance du brevet:
**29.04.2026 Bulletin 2026/18**

(21) Numéro de dépôt: **25154257.7**

(22) Date de dépôt: **27.01.2025**

(51) Classification Internationale des Brevets (IPC):
*H04Q 9/00* (2006.01)      *G01R 22/06* (2006.01)
*G08B 17/107* (2006.01)    *G08B 17/12* (2006.01)
*G01D 4/00* (2006.01)

(52) Classification Coopérative des Brevets (CPC):
**H04Q 9/00; G01D 4/008; G08B 17/107;**
G01D 2204/22; H04Q 2209/30; H04Q 2209/60

(54) **DÉTECTION D'INCENDIE PAR UN COMPTEUR ÉLECTRIQUE PRÉEXISTANT**

BRANDERKENNUNG DURCH EINEN BESTEHENDEN STROMZÄHLER

FIRE DETECTION BY A PRE-EXISTING ELECTRIC METER

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **31.01.2024 FR 2400946**

(43) Date de publication de la demande:
**06.08.2025 Bulletin 2025/32**

(73) Titulaire: **SAGEMCOM ENERGY & TELECOM SAS
92270 Bois-Colombes (FR)**

(72) Inventeurs:
• **TEBOULLE, Henri**
  **92270 BOIS-COLOMBES (FR)**
• **GRINCOURT, Christophe**
  **92270 BOIS-COLOMBES (FR)**
• **JEANROT, Marc**
  **92270 BOIS-COLOMBES (FR)**

(74) Mandataire: **Cabinet Boettcher
5, rue de Vienne
75008 Paris (FR)**

(56) Documents cités:
EP-B1- 2 083 406      FR-A1- 3 009 623
FR-A1- 3 100 409      GB-A- 2 461 348

## Description

L'invention concerne le domaine des compteurs électriques et, plus précisément, de l'amélioration des compteurs électriques préexistants.

ARRIERE PLAN

Il est possible, bien que cela soit extrêmement peu probable, que l'installation défectueuse d'un compteur électrique soit à l'origine d'un incendie.

Lorsque l'installateur connecte les câbles d'arrivée électrique au bornier du compteur, il positionne les conducteurs dans les bornes de puissance puis effectue un serrage mécanique. Or, s'il a mal serré l'un des câbles, une résistance s'établit au niveau de la borne en question. Cette résistance peut provoquer un échauffement qui, très rarement, peut être à l'origine de l'apparition d'une flamme provoquant un incendie. Ce n'est donc pas le compteur lui-même qui est à l'origine de l'incendie, mais plutôt cette installation défectueuse.

Lorsqu'un incendie survient dans le local dans lequel se trouve le compteur électrique, il est très intéressant que le compteur soit capable de détecter cet incendie et de générer un message d'alarme. Cela permet de prendre rapidement des mesures permettant de limiter les conséquences de l'incendie. Il est aussi très intéressant d'être en mesure de déterminer de manière certaine si c'est le compteur électrique qui est à l'origine de cet incendie (ou plutôt son installation en réalité), ou bien si l'incendie a une autre cause.

On cherche à mettre en œuvre cette double fonction de détection (incendie et origine de l'incendie) dans un compteur préexistant, et donc déjà conçu, voire même déjà installé chez l'abonné (et donc scellé).

Cette fonction doit donc être réalisée sans nécessiter de modification matérielle (mécanique ou électronique) du compteur et doit, si possible, présenter un coût réduit.

FR3100409 A1 divulgue déjà un système de communication, agencé pour être monté sur un compteur électrique et pour en recevoir l'alimentation.

OBJET

L'invention a pour objet :

- de détecter la survenue d'un incendie dans un local dans lequel se trouve un compteur électrique ;
- de déterminer si le compteur est ou non à l'origine de l'incendie ;
- et ce, sans modifier matériellement le compteur et avec un coût réduit.

RESUME

En vue de la réalisation de ce but, on propose un équipement accessoire agencé pour être monté sur un compteur électrique pouvant comprendre au moins un port primaire sur lequel le compteur électrique applique une tension d'alimentation, l'équipement accessoire comprenant :

- au moins un port secondaire agencé pour être connecté au au moins un port primaire lorsque l'équipement accessoire est monté sur le compteur, l'équipement accessoire étant ainsi alimenté électriquement par la tension d'alimentation ;
- une unité de traitement secondaire agencée pour transmettre au moins un message au compteur électrique en modulant un courant d'alimentation de l'équipement accessoire produit par le compteur et circulant via le au moins un port primaire et le au moins un port secondaire.

Certains compteurs électriques sont équipés d'une interface fournissant une tension et un courant d'alimentation accessibles depuis l'extérieur du compteur. Il s'agit par exemple d'une interface TIC qui comprend une fonction d'alimentation et une fonction de communication unidirectionnelle, et qui permet ainsi d'alimenter et de transmettre des données à un récepteur TIC monté sur le compteur.

L'équipement accessoire peut donc être monté sur un tel compteur, être alimenté par la tension d'alimentation de l'interface, et transmettre un message au compteur en modulant le courant d'alimentation. Le message est donc transmis au compteur par l'équipement accessoire en utilisant cette interface préexistante qui ne prévoit pourtant pas de communication bidirectionnelle.

L'équipement accessoire peut intégrer un dispositif de détection de fumée, et le message transmis au compteur peut contenir une indication relative à la présence de fumée à l'extérieur du compteur. Ceci permet non seulement de détecter un incendie, mais aussi de fournir une preuve formelle que le compteur n'est pas à l'origine de l'incendie.

L'équipement accessoire est très peu coûteux car il nécessite uniquement des composants très simples pour transmettre le message vers le compteur et pour détecter la fumée.

L'équipement accessoire est monté sur le compteur sans que cela ne nécessite de modification matérielle du compteur. Il suffit de charger un logiciel adapté dans le compteur pour que celui-ci traite les messages transmis par l'équipement accessoire (et, par exemple, émette un message d'alarme en cas d'incendie).

On propose de plus un équipement accessoire tel que précédemment décrit, l'unité de traitement secondaire comportant :

- un composant de traitement ;
- un composant de réserve d'énergie ;
- un interrupteur agencé de sorte que lorsque l'interrupteur est fermé, le composant de traitement est alimenté par le courant d'alimentation, et lorsque l'interrupteur est ouvert, le composant de traitement est alimenté par un courant de réserve provenant du composant de réserve d'énergie ;

le composant de traitement étant agencé pour moduler le courant d'alimentation en ouvrant et en fermant l'interrupteur.

On propose de plus un équipement accessoire tel que précédemment décrit, dans lequel l'unité de traitement secondaire transmet le au moins un message au compteur électrique en produisant au moins un état bas du courant d'alimentation.

On propose de plus un équipement accessoire tel que précédemment décrit, dans lequel l'unité de traitement secondaire transmet le au moins un message au compteur électrique en produisant une signature comprenant une succession prédéfinie d'états hauts et d'états bas de durées prédéfinies.

On propose de plus un équipement accessoire tel que précédemment décrit, comprenant un boîtier muni d'au moins une ouverture et dans lequel sont intégrés l'unité de traitement secondaire et un dispositif de détection de fumée, le dispositif de détection de fumée étant agencé pour détecter des particules de fumée provenant de l'extérieur de l'équipement accessoire et ayant pénétré dans l'équipement accessoire via la au moins une ouverture, le au moins un message comprenant une information relative à la présence des particules de fumée.

On propose de plus un équipement accessoire tel que précédemment décrit, le dispositif de détection de fumée comprenant un émetteur de lumière agencé pour émettre des signaux lumineux et un récepteur de lumière, qui sont positionnés dans le boîtier de l'équipement accessoire de sorte que :

-    lorsque le boîtier ne contient pas de particules de fumée, le récepteur de lumière ne détecte pas les signaux lumineux émis par l'émetteur de lumière ;
-    lorsque le boîtier contient des particules de fumée, les signaux lumineux émis par l'émetteur de lumière sont au moins partiellement réfléchis par lesdites particules de fumée et détectés par le récepteur de lumière.

On propose de plus un compteur électrique, agencé de sorte qu'un équipement accessoire tel que précédemment décrit peut être monté sur ledit compteur électrique, le compteur électrique comprenant :

-    un capteur de courant agencé pour mesurer le courant d'alimentation ;
-    une unité de traitement primaire agencée pour récupérer le au moins un message à partir de mesures de courant produites par le capteur de courant.

On propose de plus un compteur électrique tel que précédemment décrit, agencé de sorte qu'un équipement accessoire tel que précédemment décrit peut être monté sur ledit compteur électrique, l'unité de traitement primaire du compteur électrique étant agencée pour détecter un incendie survenant à l'extérieur du compteur en cas de présence de particules de fumée dans l'équipement accessoire.

On propose de plus un compteur électrique tel que précédemment décrit, dans lequel est intégré en outre un capteur de température, l'unité de traitement primaire étant agencée pour évaluer une température ambiante régnant à l'extérieur du compteur à partir de mesures de température produites par le capteur de température, l'unité de traitement primaire étant agencée pour détecter un incendie survenant à l'extérieur du compteur :

-    en cas de présence de particules de fumée dans l'équipement accessoire ;
-    et/ou si la température ambiante est supérieure à un seuil prédéfini.

On propose de plus un compteur électrique tel que précédemment décrit, l'unité de traitement primaire étant agencée pour évaluer la température ambiante à partir des mesures de température et de mesures d'un courant fourni à une installation dont une consommation d'énergie électrique est mesurée par le compteur électrique.

On propose de plus un système comprenant un équipement accessoire tel que précédemment décrit et un compteur tel que précédemment décrit.

On propose de plus un procédé de détection d'un incendie et d'une origine de l'incendie, mis en œuvre dans l'unité de traitement principale du compteur tel que précédemment décrit, et comprenant les étapes de :

-    acquérir le message comprenant l'information relative à la présence de la fumée ;
-    détecter un incendie survenant à l'extérieur du compteur en cas de présence de particules de fumée dans l'équipement accessoire.

On propose de plus un procédé tel que précédemment décrit, mis en œuvre dans l'unité de traitement principale du compteur tel que précédemment décrit, et comprenant en outre les étapes de :

-    évaluer la température ambiante régnant à l'extérieur du compteur ;
-    détecter un incendie survenant à l'extérieur du compteur en cas de présence de particules de fumée dans l'équipement accessoire, et/ou si la température ambiante est supérieure à un seuil prédéfini.

On propose de plus un programme d'ordinateur comprenant des instructions qui conduisent l'unité de traitement primaire du compteur tel que précédemment décrit à exécuter les étapes du procédé de détection d'un incendie et de l'origine de l'incendie tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés parmi lesquels :

[Fig. 1] la figure 1 représente une vue en perspective du compteur électrique, de son capot et de l'équipement accessoire ;
[Fig. 2] la figure 2 représente une vue en coupe simplifiée du compteur électrique et de l'équipement accessoire, selon un plan parallèle à la face avant du compteur ;
[Fig. 3] la figure 3 représente un schéma simplifié du compteur et de l'équipement accessoire ;
[Fig. 4] la figure 4 représente une signature utilisée par l'équipement accessoire pour transmettre un message au compteur.

DESCRIPTION DETAILLEE

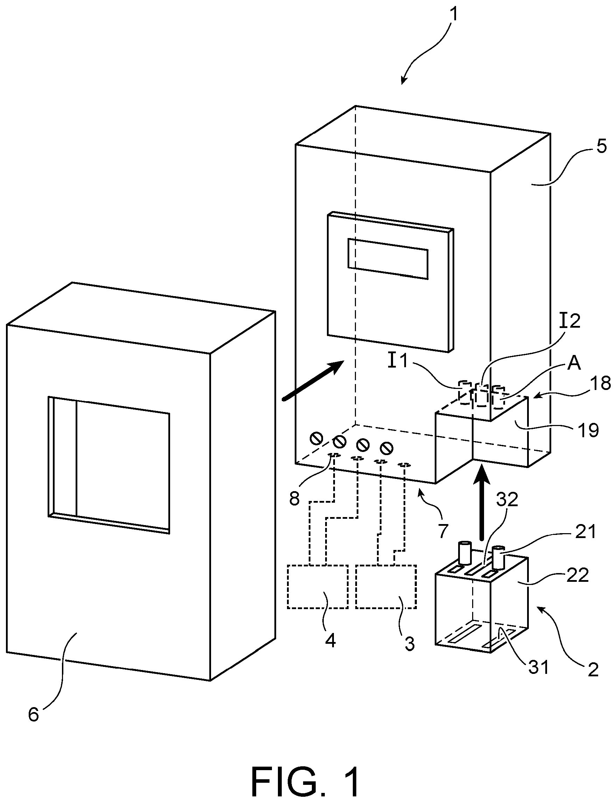

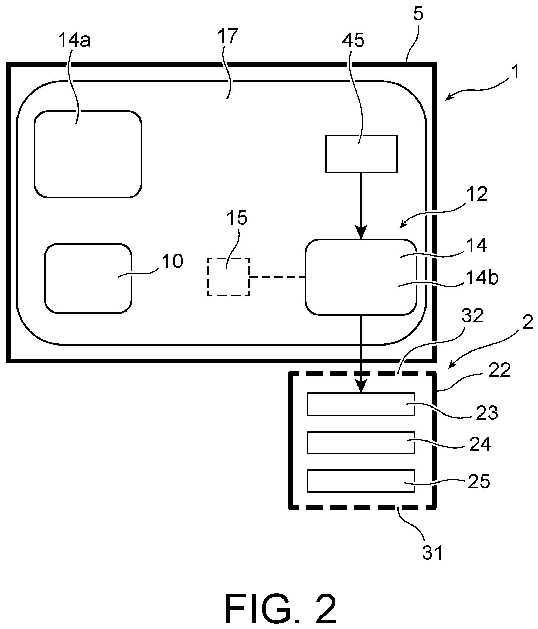

En référence aux figures 1 à 3, le compteur électrique 1 est un compteur communicant « préexistant », c'est-à-dire qu'il a été conçu préalablement à la réalisation de la présente invention et sans tenir compte de l'équipement accessoire 2.

Le compteur électrique 1 est destiné à mesurer la consommation d'énergie électrique d'une installation 3 et à transmettre les mesures au Système d'Information (SI) du fournisseur d'électricité. Cette énergie électrique est fournie à l'installation 3 par un réseau de distribution 4. Le compteur 1 est ici un compteur monophasé, mais il pourrait s'agir d'un compteur polyphasé.

Le compteur 1 est installé dans un local en étant positionné contre un mur dudit local et fixé au mur.

Le compteur 1 comporte un coffret 5 et un capot amovible 6 (fabriqués en plastique par exemple). Le coffret 5 comprend une face arrière qui est aussi la face arrière du compteur 1 et qui est destinée à être appliquée contre le mur et fixée au mur. Le capot 6 comprend une face qui est aussi la face avant du compteur 1 et qui est visible et accessible par l'abonné ou par un opérateur.

Ici, tous les termes de position (avant, arrière, supérieure, inférieure, haut, bas, etc.) doivent être interprétés en considérant que le compteur 1 est installé dans sa position nominale de fonctionnement (sa face arrière fixée à une surface verticale).

Le compteur 1 comporte un bornier 7 positionné sur la face avant du coffret, accessible en retirant le capot 6 (ainsi qu'un autre capot, non représenté, verrouillé et plombé), et comprenant des bornes de puissance 8 auxquelles sont connectés les câbles d'arrivée électrique (reliés au réseau 4) et les câbles reliés à l'installation 3.

Le compteur 1 comporte de plus des capteurs (non représentés) permettant de mesurer l'énergie électrique consommée par l'installation 3. Ces capteurs mesurent en particulier le courant circulant au travers du compteur 1 (fourni par le réseau 4 à l'installation 3) et la tension appliquée par le réseau 4 en entrée de l'installation 3 (et du compteur 1).

Le compteur 1 comporte aussi un organe de coupure 10 qui est destiné à couper sélectivement le courant fourni à l'installation 3. L'organe de coupure 10 comprend un interrupteur pour chaque phase du réseau de distribution 4 (ici un seul interrupteur).

Le compteur 1 comporte de plus une unité de traitement primaire 12 (électronique et logicielle). L'unité de traitement primaire 12 comprend au moins un composant de traitement 14, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Specific Integrated Circuit*). L'unité de traitement primaire 12 comprend aussi une ou des mémoires 15, reliées à ou intégrées dans le composant de traitement. Au moins l'une de ces mémoires 15 forme un support d'enregistrement lisible par ordinateur, sur lequel est enregistré au moins un programme d'ordinateur comprenant des instructions qui conduisent l'unité de traitement primaire 12 à exécuter les étapes du procédé de détection d'un incendie et de l'origine de l'incendie, qui sera décrit plus bas.

Ici, l'unité de traitement primaire 12 comprend un microcontrôleur « métrologie » 14a qui, notamment, acquiert les mesures réalisées par les capteurs du compteur 1 et réalise certains traitements sur lesdites mesures, et un microcontrôleur « application » 14b qui, notamment, pilote l'organe de coupure 10. C'est aussi dans le microcontrôleur application 14b qu'est mis en œuvre le procédé de détection d'un incendie et de l'origine de l'incendie.

Ici, les composants électroniques de l'unité de traitement primaire 12 et l'organe de coupure 10 sont montés sur un même circuit imprimé 17 positionné dans le coffret 5 parallèlement à la face avant de celui-ci.

Le compteur 1 comprend aussi une interface TIC 18 (pour *Télé-Information Client*). Cette interface TIC 18 comprend des composants électroniques qui sont eux aussi montés sur le circuit imprimé 17, ainsi que trois ports appelés ici I1, I2, A. Les composants électroniques de l'interface TIC 18 mettent en œuvre deux fonctions : une fonction d'alimentation et une fonction de communication.

La fonction d'alimentation consiste à appliquer entre les deux ports I1 et A une tension d'alimentation Va qui est ici une tension alternative (de fréquence par exemple égale à 50 kHz).

La fonction de communication consiste à transmettre des données par application d'une tension modulée entre les deux ports I1 et I2. La modulation est ici une modulation d'amplitude d'une fréquence porteuse égale à 50 kHz. Les données comprennent par exemple des index de consommation, des informations sur l'abonnement souscrit, etc. Cette transmission est unidirectionnelle : le compteur 1 transmet des données mais ne peut pas en recevoir par ce canal.

Le coffret 5 du compteur 1 comporte un espace d'accueil 19, formé par un renfoncement situé au niveau d'une partie inférieure de la face avant du coffret 5, et accessible lorsque le capot 6 est retiré. L'espace d'accueil 19 est conçu pour accueillir un récepteur TIC (non représenté) et pour connecter le récepteur TIC à l'interface TIC 18.

Le récepteur TIC est ainsi alimenté électriquement par la fonction d'alimentation de l'interface TIC 18, et reçoit les données émises par la fonction de communication.

Le récepteur TIC, qui intègre par exemple un module radio, peut ainsi retransmettre ces données à un opérateur ou à l'abonné.

L'équipement accessoire 2 est un équipement optionnel et amovible, qui est monté sur le compteur 1. Comme on l'a vu, le compteur 1 est un compteur préexistant. L'équipement 2 peut donc être monté sur le compteur 1 soit à la fin de l'assemblage du compteur 1, soit au moment de l'installation du compteur 1 chez l'abonné (ou entre la fin de l'assemblage et l'installation), soit même alors que le compteur 1 est déjà installé chez l'abonné.

L'équipement 2 est ici destiné à permettre au compteur 1 de détecter la survenue d'un incendie dans le local dans lequel est positionné le compteur 1, mais aussi à fournir la preuve formelle que le compteur 1 n'est pas à l'origine de cet incendie.

L'équipement 2 est connecté au compteur 1 via l'interface TIC 18. Il est monté sur le coffret 5 en étant positionné dans l'espace d'accueil 19 qui vient d'être évoqué.

L'équipement 2 comprend au moins un port secondaire 21 agencé pour être connecté à au moins un port primaire du compteur 1 lorsque l'équipement 2 est monté sur le compteur 1. L'équipement 2 comprend en l'occurrence deux ports secondaires 21 qui sont connectés à deux ports primaires du compteur 1. Les deux ports primaires du compteur 1 sont les ports I1 et A. L'équipement 2 est ainsi alimenté électriquement par la tension d'alimentation Va appliquée par le compteur 1 entre ces ports. La consommation électrique de l'équipement 2 est typiquement égale à 130 mW.

L'équipement 2 comprend un boîtier 22 à l'intérieur duquel sont intégrés une unité d'alimentation 23, une unité de traitement secondaire 24 et un dispositif de détection de fumée 25.

L'unité d'alimentation 23 comprend ici un redresseur 26 qui redresse la tension d'alimentation alternative Va, produite par le compteur 1, pour produire une tension d'alimentation continue Vc (5V par exemple). L'unité d'alimentation 23 comprend deux entrées E1, E2 reliées chacune à l'un des ports secondaires 21 (et donc à l'un des ports primaires I1, A lorsque l'équipement 2 est monté sur le compteur 1), et deux sorties S1, S2 (une sortie S1 de potentiel haut et une sortie S2 de potentiel bas) entre lesquelles est appliquée la tension d'alimentation continue Vc produite par l'unité d'alimentation 23 à partir de la tension d'alimentation alternative Va.

L'unité de traitement secondaire 24 comprend au moins un composant de traitement 28, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Specific Integrated Circuit*). L'unité de traitement secondaire 24 comprend aussi une ou des mémoires 29, reliées à ou intégrées dans le composant de traitement 28. Au moins l'une de ces mémoires 29 forme un support d'enregistrement lisible par ordinateur, sur lequel est enregistré au moins un programme d'ordinateur comprenant des instructions qui conduisent l'unité de traitement secondaire 24 à exécuter les étapes du procédé de détection de fumée et de communication, qui sera décrit plus bas.

Ici, l'unité de traitement secondaire 24 comprend un microcontrôleur 28.

Le dispositif de détection de fumée 25 permet de détecter la présence ou l'absence de fumée à l'extérieur du compteur 1.

Le boîtier 22 de l'équipement 2 comprend au moins une ouverture, et avantageusement au moins une première ouverture 31 (en l'occurrence plusieurs) et au moins une deuxième ouverture 32 (en l'occurrence plusieurs).

Les premières ouvertures 31 sont positionnées au niveau d'une partie inférieure du boîtier 22 de l'équipement 2 (lorsque celui-ci est monté sur le compteur 1). Les deuxièmes ouvertures 32 sont positionnées au niveau d'une portion supérieure du boîtier 22 de l'équipement 2.

Les premières ouvertures 31 forment une entrée d'air, par laquelle de l'air peut pénétrer dans l'équipement 2. Les deuxièmes ouvertures 32 forment une sortie d'air, par laquelle l'air peut sortir de l'équipement 2.

Les premières ouvertures 31 et les deuxièmes ouvertures 32 confèrent à l'équipement 2 une forme de « cage ».

Lorsque l'équipement 2 est monté sur le compteur 1, il subsiste un espace entre l'équipement 2 et le compteur 1 permettant à l'air de s'échapper par les deuxièmes ouvertures 32.

L'entrée d'air et la sortie d'air créent une circulation d'air. Ainsi, lorsque de la fumée est présente dans le local à l'extérieur du compteur 1, dans l'environnement du compteur 1, cette fumée s'engouffre dans l'équipement 2 via l'entrée d'air 31 et y est emprisonnée.

Le dispositif de détection de fumée 25 détecte des particules de fumée provenant de l'extérieur de l'équipement 2 et ayant pénétré dans l'équipement 2 via la au moins une première ouverture 31.

Le dispositif de détection de fumée 25 comprend un émetteur de lumière, en l'occurrence une diode électroluminescente 34 (LED), et un récepteur de lumière, en l'occurrence une photodiode 35. La LED 34 génère ici une lumière infrarouge (par exemple de longueur d'onde égale à 860 nm), que peut détecter la photodiode 35 lorsque les rayons lumineux atteignent sa cellule sensible.

La LED 34 émet des signaux lumineux 36. La LED 34 et la photodiode 35 sont positionnées dans le boîtier 22 de l'équipement 2 de sorte que :

- lorsque le boîtier 22 ne contient pas de particules de fumée, la photodiode 35 ne détecte pas les signaux lumineux 36 émis par la LED 34 ;
- lorsque le boîtier 22 contient des particules de fumée, les signaux lumineux 36 émis par la LED 34 sont au moins partiellement réfléchis par lesdites particules de fumée et sont détectés par la photodiode 35.

Ici, la LED 34 et la photodiode 35 sont positionnées dans le boîtier 22 de l'équipement 2 de sorte que la LED 34 émet des signaux lumineux selon un premier axe X1, et la photodiode 35 détecte de manière optimale des signaux lumineux arrivant sur sa cellule sensible selon un deuxième axe X2 qui est perpendiculaire au premier axe X1. Ainsi, en l'absence de particules de fumée dans le boîtier 22 de l'équipement 2, la photodiode 35 ne détecte pas les signaux lumineux émis par la LED 34. Par contre, en présence de particules de fumée, une partie des signaux lumineux émis par la LED 34 sont réfléchis par les particules de fumée et atteignent la photodiode 35.

La photodiode 35 produit en sortie un signal électrique binaire.

En l'absence de fumée, ce signal binaire prend une première valeur.

Lorsque la quantité de particules de fumée présentes dans la partie secondaire dépasse un certain seuil, le signal électrique binaire prend une deuxième valeur.

Le microcontrôleur 28 comprend un port P1 connecté à la LED 34 et un port P2 connecté à la photodiode 35. Le microcontrôleur 28 produit régulièrement une tension qu'il applique aux bornes de la LED 34 via le port P1 pour que celle-ci émette des signaux lumineux, et acquiert via le port P2 le signal électrique binaire produit par la photodiode 35 pour détecter l'absence ou la présence de fumée dans le boîtier 22 de l'équipement 2 et donc dans le local.

Le message, transmis par l'équipement 2 au compteur 1, comprend donc une information relative à la présence des particules de fumée dans l'équipement 2 (et donc dans le local à l'extérieur de l'équipement 2).

Cependant, comme on l'a vu plus tôt, la fonction de communication de l'interface TIC 18 est unidirectionnelle et ne peut pas être utilisée par l'équipement 2 pour transmettre un message structuré au compteur 1 via les deux ports I1 et I2.

L'unité de traitement secondaire 24 comprend donc des composants lui permettant de transmettre des messages via les ports secondaires 21 et donc via les ports primaires I1, A du compteur 1, qui sont des ports d'alimentation (et donc non prévus initialement pour réceptionner des données).

Ces composants comprennent un composant de réserve d'énergie 40 et un interrupteur 41, qui sont utilisés pour transmettre au compteur 1 le message comprenant l'information relative à la présence des particules de fumée.

Le composant de réserve d'énergie est une capacité réservoir 40, par exemple une capacité chimique 10V / 470 $\mu$F. La valeur de capacité pourrait bien sûr être différente.

La transmission d'informations fonctionne de la manière suivante.

L'interrupteur 41 est monté entre la sortie de potentiel haut S1 de l'unité d'alimentation 23 et un port d'alimentation P3 du microcontrôleur 28.

La capacité 40 a une première borne qui est connectée à l'interrupteur 41 et au port d'alimentation P3.

La sortie de potentiel bas S2 de l'unité d'alimentation 23 est connectée à un port de masse P4 du microcontrôleur 28. La capacité 40 a une deuxième borne qui est connectée à la sortie de potentiel bas S2 et au port de masse P4.

Le microcontrôleur 28 a un port CMDE qui est connecté à l'interrupteur 41 et via lequel il peut piloter l'interrupteur 41 et le placer sélectivement dans un état passant (fermé : CMDE est dans un état haut) ou bloqué (ouvert : CMDE est dans un état bas).

L'unité de traitement secondaire 24 de l'équipement 2 transmet le message au compteur 1 en modulant le courant d'alimentation Ia de l'équipement 2 produit par le compteur 1 et circulant via les ports primaires I1, A et les ports secondaires 21. Le courant d'alimentation Ia est donc le courant qui alimente l'équipement 2 sous la tension d'alimentation Va.

La modulation est réalisée via l'interrupteur 41. L'interrupteur 41 est « normalement fermé ».

Lorsque l'interrupteur 41 est fermé, le microcontrôleur 28 est alimenté par le courant d'alimentation Ia fourni par la fonction d'alimentation de l'interface TIC 18, et lorsque l'interrupteur 41 est ouvert, le microcontrôleur 28 est alimenté par un courant de réserve Ir provenant de la capacité 40.

Ainsi, normalement, le microcontrôleur 28 est alimenté par le courant d'alimentation Ia provenant du compteur 1. Le courant d'alimentation tiré Ia est constant, par exemple de l'ordre de 100 mA, ce qui confère au courant d'alimentation un « état haut » continu.

Lorsque le microcontrôleur 28 détecte des particules de fumée, il commande l'interrupteur 41 pendant une durée prédéfinie, de 500 ms par exemple, pour couper son alimentation via l'unité d'alimentation 23. L'équipement 2, et donc en particulier le microcontrôleur 28, est alors autoalimenté par la capacité réservoir 40. L'équipement 2 ne tire donc plus de courant, ce qui produit pendant la durée prédéfinie un état bas du courant d'alimentation Ia.

Or, le compteur 1 est capable de détecter une variation du courant d'alimentation Ia fourni via l'interface TIC 18, et donc une variation de charge entre les ports I1 et A.

Le compteur 1 comprend en effet un capteur de courant 43 qui mesure le courant d'alimentation fourni par la fonction d'alimentation de l'interface TIC 18. Le microcontrôleur application 14b récupère donc l'information relative à la présence de la fumée à partir de mesures de courant produites par ce capteur de courant 43.

Le message transmis par l'équipement 2 au compteur 1 l'est donc via un état bas de durée prédéfinie. Il serait possible de transmettre différents messages en utilisant des états bas de durées différentes.

Le ou les messages transmis par l'équipement 2 au compteur 1 ne le sont pas nécessairement par un ou des états bas du courant d'alimentation Ia.

Le ou les messages pourraient aussi être transmis chacun par une signature temporelle comprenant une succession prédéfinie d'états hauts et d'états bas de durées prédéfinies.

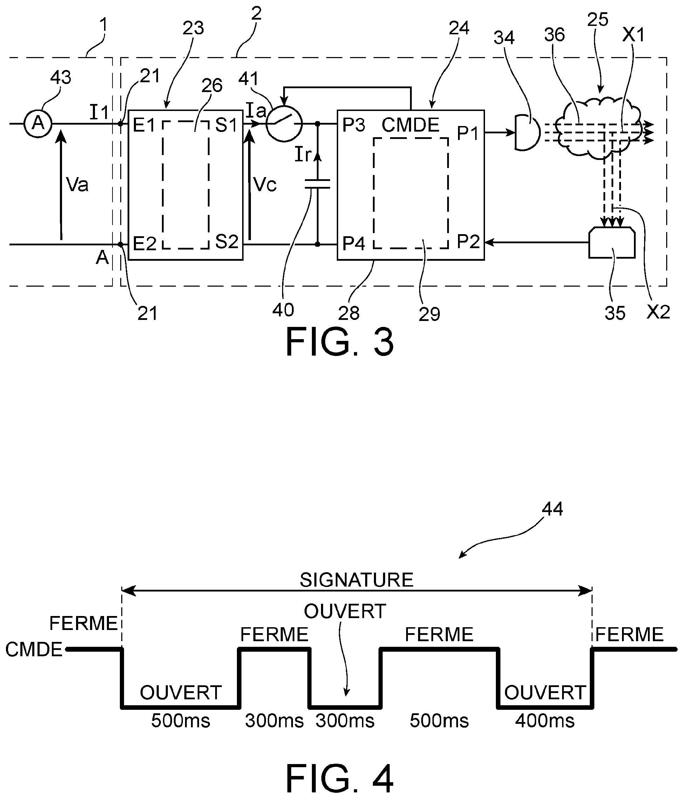

Une telle signature 44 est visible sur la figure 4. Cette signature comprend un premier état bas d'une durée de 500ms, un deuxième état bas d'une durée de 300 ms et un troisième état bas d'une durée de 400 ms. Le premier état bas et le deuxième état bas sont séparés par un état haut d'une durée de 300 ms. Le deuxième état bas et le troisième état bas sont séparés par un état haut d'une durée de 500 ms. Cette complexification de la signature permet d'augmenter la robustesse de la transmission d'informations.

Il serait bien sûr possible d'avoir des signatures différentes pour transmettre au compteur des messages différents.

Le microcontrôleur application 14b détecte donc un incendie survenant à l'extérieur du compteur 1 en cas de présence de particules de fumée dans l'équipement 2.

Avantageusement, le compteur 1 utilise aussi une information de température fournie par un capteur de température 45 intégré dans le compteur (préexistant).

Le capteur de température 45 est en l'occurrence une thermistance de type CTN (pour *Coefficient de Température Négatif*).

La thermistance 45 est montée sur le circuit imprimé 17 et est située à un point non chaud dans le coffret 5. Elle est donc éloignée de l'organe de coupure 10. Ici, la thermistance 45 est située à proximité d'un premier coin du circuit imprimé 17 et l'organe de coupure 10 est situé à proximité d'un deuxième coin du circuit imprimé 17, le premier coin et le deuxième coin étant diagonalement opposés.

Cette thermistance 45 peut être utilisée pour évaluer la température ambiante régnant dans le local à l'extérieur du compteur 1.

La température mesurée par la thermistance 45 n'est pas directement la température ambiante, mais une image de cette dernière.

L'écart entre la température mesurée par la thermistance 45 et la température ambiante est fonction du courant $I$ circulant au travers du compteur 1 (et consommé par l'installation 3), et donc via l'organe de coupure 10. Le courant $I$ provoque un échauffement interne dans le compteur 1 qui par diffusion va agir sur la température mesurée par la thermistance 45 et ce, quelle que soit la température ambiante.

L'unité de traitement primaire 12 est donc agencée pour évaluer la température ambiante à partir des mesures de température produites par la thermistance 45 et de mesures du courant fourni à l'installation 3 dont la consommation d'énergie électrique est mesurée par le compteur électrique 1.

La température $\Theta$ mesurée par la thermistance 45 est donc fonction de la température ambiante *Tamb* (ambiante autour du compteur 1 dans son environnement extérieur dans le local où il se trouve) et de la valeur du courant $I$ (qui peut aller typiquement de 0 à 100 A, et qui peut être égale à 200 A aux USA) :

$$\Theta \; = \; Tamb \; + \; \Delta T \; + \; K * I^2$$

$\Delta$T étant déterminé par conception et typiquement égal à 10 °C, et K étant un facteur déterminé également par conception et étant tel que, typiquement :

$$K \; = \; 0,025\,°C/A^2$$

A titre d'exemple, si on a un courant de 60 A traversant le compteur 1, on aura un écart entre $\Theta$ et *Tamb* de :

$$(10 + 0.025 * 60^2) = 19°C\,.$$

Le microcontrôleur application 14b mesure donc la résistance de la thermistance 45, en déduit la température $\Theta$, puis déduit de la température $\Theta$ la température ambiante *Tamb*. Le microcontrôleur application 14b peut donc estimer en temps réel la température ambiante *Tamb*.

Le microcontrôleur application 14b détecte alors un incendie survenant à l'extérieur du compteur 1 :

- en cas de présence de particules de fumée dans l'équipement 2 ;
- et/ou si la température ambiante est supérieure à un seuil prédéfini, et est donc anormalement élevée.

Le seuil prédéfini est par exemple égal à 60°C.

Le microcontrôleur application 14b déclenche une première alarme dans le cas de la présence de particules de fumée. Le microcontrôleur application 14b déclenche une deuxième alarme dans le cas d'une température anormalement élevée.

Si l'une de ces alarmes est déclenchée (ou les deux), le compteur 1 détecte un incendie. Le compteur 1 envoie alors un message d'alarme correspondant au HES (pour *Head End System*) du SI du fournisseur d'électricité. Le message d'alarme peut être un premier message d'alarme indiquant « température ambiante anormalement élevée », ou bien un deuxième message d'alarme indiquant « présence de fumée ». Les deux messages d'alarme peuvent être envoyés simultanément.

Comme on l'a vu, un incendie va généralement provoquer le déclenchement d'au moins l'une des deux alarmes voire les deux. Le compteur 1 va donc signaler, via le ou les messages d'alarme, qu'il détecte un probable incendie dans son environnement avant qu'il ne soit lui-même détruit.

L'envoi et la réception de ce ou ces messages d'alarme constituent une preuve formelle que le compteur 1 lui-même n'est pas à l'origine de l'incendie, et permettent de mettre le compteur 1 hors de cause. En effet, si l'incendie a pour origine le compteur 1 (ou plutôt son installation défectueuse a priori), le compteur 1 ne va pas détecter immédiatement une température ambiante anormalement élevée ni de la fumée car il se consume de l'intérieur. Il n'aura donc pas le temps d'envoyer un message d'alarme au HES du SI car il sera détruit avant. Le fait que le HES ait reçu au moins un des deux messages d'alarme lui permet de mettre hors de cause le compteur 1 en cas d'incendie.

Bien entendu, l'invention n'est pas limitée au mode de réalisation décrit mais englobe toute variante entrant dans le champ de l'invention tel que défini par les revendications.

L'équipement accessoire pourrait relayer l'interface TIC vers un deuxième module (récepteur TIC), qui serait connecté à l'équipement accessoire. Le positionnement de l'équipement accessoire sur le compteur dans l'espace d'accueil normalement réservé au récepteur TIC n'empêche donc pas de connecter un récepteur TIC « classique » au compteur.

L'équipement accessoire consommant typiquement 130 mW, le compteur, même s'il y a un deuxième module TIC connecté derrière l'équipement accessoire, reconnaît qu'il s'agit du signal de détection de fumée lorsqu'il constate une variation de charge d'au moins 100 mW. La réception des données est bien sûr plus robuste avec une signature adéquate (celle de la figure 4 par exemple).

L'interface via laquelle l'équipement accessoire est alimenté et communique avec le compteur n'est pas forcément une interface TIC. Il pourrait s'agir d'une autre interface de communication, par exemple un port série tel un port P1, à ne pas confondre avec le port P1 de la figure 3.

Le dispositif de détection de fumée pourrait être différent. La longueur d'onde des signaux lumineux émis pourrait être différente. Les composants utilisés pourraient être différents (par exemple, un phototransistor au lieu d'une photodiode). Plus généralement, toute type de technologie peut être utilisé (par exemple un détecteur optique linéaire).

L'équipement accessoire ne comprend pas nécessairement un dispositif de détection de fumée, et le ou les messages transmis ne sont donc pas forcément des messages informant le compteur de la présence de fumée. Le compteur pourrait par exemple contrôler via l'équipement accessoire des relais de coupure dans une installation, ce qui permet notamment de faire du délestage « intelligent ». L'équipement accessoire intègre alors un module radio pour commander à distance les relais de coupure. Dans ce cas, suite à la réception de la commande, le relais de coupure émet un acquittement qui est reçu par l'équipement accessoire puis retransmis au compteur par modulation du courant d'alimentation.

**Revendications**

1. Equipement accessoire (2) agencé pour être monté sur un compteur électrique (1) pouvant comprendre au moins un port primaire (I1, A) sur lequel le compteur électrique applique une tension d'alimentation (Va), l'équipement accessoire comprenant :

   - au moins un port secondaire (21) agencé pour être connecté au au moins un port primaire lorsque l'équipement accessoire est monté sur le compteur, l'équipement accessoire étant ainsi alimenté électriquement par la tension d'alimentation ;
   - une unité de traitement secondaire (24) agencée pour transmettre au moins un message au compteur électrique en modulant un courant d'alimentation (Ia) de l'équipement accessoire produit par le compteur et circulant via le au moins un port primaire et le au moins un port secondaire.

2. Equipement accessoire selon la revendication 1, l'unité de traitement secondaire comportant :

   - un composant de traitement (28) ;
   - un composant de réserve d'énergie (40) ;
   - un interrupteur (41) agencé de sorte que lorsque l'interrupteur est fermé, le composant de traitement est alimenté par le courant d'alimentation, et lorsque l'interrupteur est ouvert, le composant de traitement est alimenté par un courant de réserve provenant du composant de réserve d'énergie ;

le composant de traitement étant agencé pour moduler le courant d'alimentation en ouvrant et en fermant l'interrupteur.

3. Equipement accessoire selon l'une des revendications précédentes, dans lequel l'unité de traitement secondaire (24) transmet le au moins un message au compteur électrique en produisant au moins un état bas du courant d'alimentation.

4. Equipement accessoire selon la revendication 3, dans lequel l'unité de traitement secondaire (24) transmet le au moins un message au compteur électrique en produisant une signature (44) comprenant une succession prédéfinie d'états hauts et d'états bas de durées prédéfinies.

5. Equipement accessoire selon l'une des revendications précédentes, comprenant un boîtier (22) muni d'au moins une ouverture (31) et dans lequel sont intégrés l'unité de traitement secondaire (24) et un dispositif de détection de fumée (25), le dispositif de détection de fumée étant agencé pour détecter des particules de fumée provenant de l'extérieur de l'équipement accessoire et ayant pénétré dans l'équipement accessoire via la au moins une ouverture, le au moins un message comprenant une information relative à la présence des particules de fumée.

6. Equipement accessoire selon la revendication 5, le dispositif de détection de fumée comprenant un émetteur de lumière (34) agencé pour émettre des signaux lumineux (36) et un récepteur de lumière (35), qui sont positionnés dans le boîtier (22) de l'équipement accessoire de sorte que :

- lorsque le boîtier (22) ne contient pas de particules de fumée, le récepteur de lumière (35) ne détecte pas les signaux lumineux émis par l'émetteur de lumière ;
- lorsque le boîtier contient des particules de fumée, les signaux lumineux émis par l'émetteur de lumière sont au moins partiellement réfléchis par lesdites particules de fumée et détectés par le récepteur de lumière.

7. Compteur électrique (1), agencé de sorte qu'un équipement accessoire (2) selon l'une des revendications précédentes peut être monté sur ledit compteur électrique, le compteur électrique comprenant :

- un capteur de courant (43) agencé pour mesurer le courant d'alimentation ;
- une unité de traitement primaire (12) agencée pour récupérer le au moins un message à partir de mesures de courant produites par le capteur de courant (43).

8. Compteur électrique selon la revendication 7, agencé de sorte qu'un équipement accessoire (2) selon l'une des revendications 5 ou 6 peut être monté sur ledit compteur électrique, l'unité de traitement primaire (12) du compteur électrique étant agencée pour détecter un incendie survenant à l'extérieur du compteur en cas de présence de particules de fumée dans l'équipement accessoire.

9. Compteur électrique selon la revendication 8, dans lequel est intégré en outre un capteur de température (45), l'unité de traitement primaire (12) étant agencée pour évaluer une température ambiante régnant à l'extérieur du compteur à partir de mesures de température produites par le capteur de température, l'unité de traitement primaire étant agencée pour détecter un incendie survenant à l'extérieur du compteur :

- en cas de présence de particules de fumée dans l'équipement accessoire ;
- et/ou si la température ambiante est supérieure à un seuil prédéfini.

10. Compteur électrique selon la revendication 9, l'unité de traitement primaire étant agencée pour évaluer la température ambiante à partir des mesures de température et de mesures d'un courant fourni à une installation (3) dont une consommation d'énergie électrique est mesurée par le compteur électrique (1).

11. Système comprenant un équipement accessoire (2) selon l'une des revendications 1 à 6 et un compteur (1) selon l'une des revendications 7 à 10.

12. Procédé de détection d'un incendie et d'une origine de l'incendie, mis en œuvre dans l'unité de traitement principale (12) du compteur (1) selon la revendication 8, et comprenant les étapes de :

- acquérir le message comprenant l'information relative à la présence de la fumée ;
- détecter un incendie survenant à l'extérieur du compteur en cas de présence de particules de fumée dans l'équipement accessoire.

13. Procédé selon la revendication 12, mis en œuvre dans l'unité de traitement principale (12) du compteur (1) selon la revendication 9, et comprenant en outre les étapes de :

- évaluer la température ambiante régnant à l'extérieur du compteur ;
- détecter un incendie survenant à l'extérieur du compteur en cas de présence de particules de fumée dans l'équipement accessoire, et/ou si la température ambiante est supérieure à un seuil prédéfini.

14. Programme d'ordinateur comprenant des instructions qui conduisent l'unité de traitement primaire (12) du compteur selon l'une des revendications 8 à 10 à exécuter les étapes du procédé de détection d'un incendie et de l'origine de l'incendie selon la revendication 12.

15. Support d'enregistrement lisible par ordinateur, sur lequel est enregistré le programme d'ordinateur selon la revendication 14.

**Patentansprüche**

1. Zusatzeinrichtung (2) zur Anbringung an einem Stromzähler (1), der zumindest einen Primäranschluss (I1, A) aufweisen kann, an welchen der Stromzähler eine Versorgungsspannung (Va) anlegt, wobei die Zusatzeinrichtung umfasst:

   - zumindest einen Sekundäranschluss (21), der dafür ausgelegt ist, bei der Anbringung der Zusatzeinrichtung an dem Zähler an den zumindest einen Primäranschluss angeschlossen zu werden, sodass die Zusatzeinrichtung über die Versorgungsspannung mit Strom versorgt wird;
   - eine sekundäre Verarbeitungseinheit (24), die dafür ausgelegt ist, die zumindest eine Meldung an den Stromzähler zu senden, indem sie einen Versorgungsstrom (Ia) der Zusatzeinrichtung moduliert, der von dem Zähler erzeugt wird und der über den zumindest einen Primäranschluss sowie den zumindest einen Sekundäranschluss fließt.

2. Zusatzeinrichtung nach Anspruch 1, wobei die sekundäre Verarbeitungseinheit enthält:

   - eine Verarbeitungskomponente (28);
   - eine Energiereservekomponente (40);
   - einen Schalter (41), der derart ausgelegt ist, dass bei geschlossenem Schalter die Verarbeitungskomponente mit dem Versorgungsstrom versorgt wird und bei geöffnetem Schalter die Verarbeitungskomponente mit einem Reservestrom aus der Energiereservekomponente versorgt wird;

   wobei die Verarbeitungskomponente, dafür ausgelegt ist, durch das Öffnen bzw. Schließen des Schalters den Versorgungsstrom zu modulieren.

3. Zusatzeinrichtung nach einem der vorhergehenden Ansprüche, wobei die sekundäre Verarbeitungseinheit (24) die zumindest eine Meldung an den Stromzähler sendet, indem sie zumindest einen Low-Zustand des Versorgungsstroms erzeugt.

4. Zusatzeinrichtung nach Anspruch 3, wobei die sekundäre Verarbeitungseinheit (24) die zumindest eine Meldung an den Stromzähler sendet, indem sie eine Signatur (44) erzeugt, die eine vorgegebene Folge von High- und Low-Zuständen von jeweils vorgegebener Zeitdauer umfasst.

5. Zusatzeinrichtung nach einem der vorhergehenden Ansprüche, umfassend ein mit zumindest einer Öffnung (31) versehenes Gehäuse (22), in welchem die sekundäre Verarbeitungseinheit (24) und eine Rauchmeldevorrichtung (25) eingebaut sind, wobei die Rauchmeldevorrichtung dafür ausgelegt ist, Rauchpartikel zu erkennen, die aus der Umgebung der Zusatzeinrichtung kommend über die zumindest eine Öffnung in besagte Zusatzeinrichtung gelangt sind, wobei die zumindest eine Meldung eine Information über das Vorhandensein der Rauchpartikel umfasst.

6. Zusatzeinrichtung nach Anspruch 5, wobei die Rauchmeldevorrichtung einen Lichtemitter (34) zur Aussendung von Lichtsignalen (36) und einen Lichtempfänger (35) umfasst, welche derart in dem Gehäuse (22) der Zusatzeinrichtung positioniert sind, dass:

   - wenn das Gehäuse (22) keine Rauchpartikel enthält, der Lichtempfänger (35) die von dem Lichtemitter ausgesendeten Lichtsignale nicht erkennt;
   - wenn das Gehäuse Rauchpartikel enthält, die von dem Lichtemitter ausgesendeten Lichtsignale zumindest teilweise von den Rauchpartikeln reflektiert werden und so von dem Lichtempfänger erkannt werden.

7. Stromzähler (1), welcher derart ausgelegt ist, dass eine Zusatzeinrichtung (2) nach einem der vorhergehenden Ansprüche an den Stromzähler angebracht werden kann, wobei der Stromzähler umfasst:

   - einen Stromsensor (43) zur Messung des Versorgungsstroms;
   - eine primäre Verarbeitungseinheit (12), die dafür ausgelegt ist, anhand der von dem Stromsensor (43) erzeugten Strommesswerte die zumindest eine Meldung auszulesen.

**8.** Stromzähler nach Anspruch 7, welcher derart ausgelegt ist, dass eine Zusatzeinrichtung (2) nach einem der Ansprüche 5 oder 6 an den Stromzähler angebracht werden kann, wobei die primäre Verarbeitungseinheit (12) des Stromzählers dafür ausgelegt ist, einen Brandausbruch in der Umgebung des Zählers zu erkennen, wenn Rauchpartikel im Inneren der Zusatzeinrichtung vorhanden sind.

**9.** Stromzähler nach Anspruch 8, in welchem ferner ein Temperatursensor (45) eingebaut ist, wobei die primäre Verarbeitungseinheit (12) dafür ausgelegt ist, anhand von Temperaturmesswerten, die durch den Temperatursensor erzeugt werden, eine in der Umgebung des Zählers herrschende Umgebungstemperatur auszuwerten, wobei die primäre Verarbeitungseinheit dafür ausgelegt ist, einen Brandausbruch in der Umgebung des Zählers zu erkennen:

- wenn Rauchpartikel in der Zusatzeinrichtung vorhanden sind;
- und/oder wenn die Umgebungstemperatur einen vorgegebenen Schwellenwert übersteigt.

**10.** Stromzähler nach Anspruch 9, wobei die primäre Verarbeitungseinheit dafür ausgelegt ist, anhand der Temperaturmesswerte und anhand von Messwerten eines Stroms, der an eine Anlage (3) bereitgestellt wird, deren elektrischer Energieverbrauch von dem Stromzähler (1) gemessenen wird, besagte Umgebungstemperatur auszuwerten.

**11.** System, umfassend eine Zusatzeinrichtung (2) nach einem der Ansprüche 1 bis 6 und einen Zähler (1) nach einem der Ansprüche 7 bis 10.

**12.** Verfahren zur Erkennung eines Brandes und einer Brandursache, welches in der Hauptverarbeitungseinheit (12) des Zählers (1) nach Anspruch 8 ausgeführt wird und die Schritte umfasst, dass:

- die Meldung, welche die Information über das Vorhandensein von Rauch umfasst, erfasst wird;
- ein Brandausbruch in der Umgebung des Zählers erkannt wird, wenn Rauchpartikel in der Zusatzeinrichtung vorhanden sind.

**13.** Verfahren nach Anspruch 12, welches in der Hauptverarbeitungseinheit (12) des Zählers (1) nach Anspruch 9 ausgeführt wird und ferner die Schritte umfasst, dass:

- die in der Umgebung des Zählers herrschende Umgebungstemperatur ausgewertet wird;
- ein Brandausbruch in der Umgebung des Zählers erkannt wird, wenn Rauchpartikel im Inneren der Zusatzeinrichtung vorhanden sind, und/oder wenn die Umgebungstemperatur einen vorgegebenen Schwellenwert übersteigt.

**14.** Computerprogramm, das Befehle umfasst, welche die primäre Verarbeitungseinheit (12) des Zählers nach einem der Ansprüche 8 bis 10 dazu veranlassen, die Schritte des Verfahrens zur Erkennung eines Brandes und der Brandursache nach Anspruch 12 auszuführen.

**15.** Computerlesbares Speichermedium, auf welchem das Computerprogramm nach Anspruch 14 abgespeichert ist.

**Claims**

**1.** Ancillary apparatus (2) arranged to be mounted on an electricity meter (1) which may comprise at least one primary port (I1, A) to which the electricity meter applies a supply voltage (Va), the ancillary apparatus comprising:

- at least one secondary port (21) arranged to be connected to the at least one primary port when the ancillary apparatus is mounted on the meter, the ancillary apparatus thus being electrically powered by the supply voltage;
- a secondary processing unit (24) arranged to transmit at least one message to the electricity meter by modulating a supply current (Ia) of the ancillary apparatus that is produced by the meter and flows via the at least one primary port and the at least one secondary port.

**2.** Ancillary apparatus according to claim 1, the secondary processing unit comprising:

- a processing component (28);
- an energy reserve component (40);
- a switch (41) arranged such that when the switch is closed the processing component is powered by the supply current, and when the switch is open the processing component is powered by a reserve current from the energy reserve component;

the processing component being arranged to modulate the supply current by opening and closing the switch.

**3.** Ancillary apparatus according to any of the preceding claims, wherein the secondary processing unit (24) transmits the at least one message to the electricity meter by producing at least one low state of the supply current.

**4.** Ancillary apparatus according to claim 3, wherein the secondary processing unit (24) transmits the at least one message to the electricity meter by producing a signature (44) comprising a predefined sequence of high states and low states with predefined durations.

5. Ancillary apparatus according to any of the preceding claims, comprising a housing (22) provided with at least one opening (31) and in which the secondary processing unit (24) and a smoke detection device (25) are integrated, the smoke detection device being arranged to detect smoke particles that have come from outside the ancillary apparatus and entered the ancillary apparatus through the at least one opening, the at least one message containing information relating to the presence of the smoke particles.

6. Ancillary apparatus according to claim 5, the smoke detection device comprising a light emitter (34), arranged to emit light signals (36), and a light receiver (35), which are positioned in the housing (22) of the ancillary apparatus such that:

   - when the housing (22) does not contain smoke particles, the light receiver (35) does not detect the light signals emitted by the light emitter;
   - when the housing contains smoke particles, the light signals emitted by the light emitter are at least partly reflected by said smoke particles and detected by the light receiver.

7. Electricity meter (1) arranged so that an ancillary apparatus (2) according to any of the preceding claims can be mounted on said electricity meter, the electricity meter comprising:

   - a current sensor (43) arranged to measure the supply current;
   - a primary processing unit (12) arranged to retrieve the at least one message from current measurements produced by the current sensor (43).

8. Electricity meter according to claim 7, arranged such that an ancillary apparatus (2) according to any of claims 5 or 6 can be mounted on said electricity meter, the primary processing unit (12) of the electricity meter being arranged to detect a fire occurring outside the meter when smoke particles are present in the ancillary apparatus.

9. Electricity meter according to claim 8, wherein a temperature sensor (45) is also included, the primary processing unit (12) being arranged to evaluate an ambient temperature outside the meter from temperature measurements produced by the temperature sensor, the primary processing unit being arranged to detect a fire occurring outside the meter:

   - if smoke particles are present in the ancillary apparatus;
   - and/or if the ambient temperature is above a predefined threshold.

10. Electricity meter according to claim 9, the primary processing unit being arranged to evaluate the ambient temperature from the temperature measurements and from measurements of a current supplied to an installation (3), the electrical energy consumption of which is measured by the electricity meter (1).

11. System comprising an ancillary apparatus (2) according to any of claims 1 to 6 and a meter (1) according to any of claims 7 to 10.

12. Method for detecting a fire and a cause of the fire, carried out in the main processing unit (12) of the meter (1) according to claim 8 and comprising the steps of:

   - acquiring the message that contains the information relating to the presence of the smoke;
   - detecting a fire occurring outside the meter if smoke particles are present in the ancillary apparatus.

13. Method according to claim 12, carried out in the main processing unit (12) of the meter (1) according to claim 9 and further comprising the steps of:

   - evaluating the ambient temperature outside the meter;
   - detecting a fire occurring outside the meter if smoke particles are present in the ancillary apparatus and/or if the ambient temperature is above a predefined threshold.

14. Computer program comprising instructions that cause the primary processing unit (12) of the meter according to any of claims 8 to 10 to execute the steps of the method according to claim 12 for detecting a fire and the cause of the fire.

15. Computer-readable storage medium on which the computer program according to claim 14 is stored.

FIG. 1

FIG. 2

FIG. 3

SIGNATURE

FERME

CMDE

OUVERT
500ms

FERME
300ms

OUVERT
300ms

FERME
500ms

OUVERT
400ms

FERME

FIG. 4

**RÉFÉRENCES CITÉES DANS LA DESCRIPTION**

**Documents brevets cités dans la description**

- FR 3100409 A1